# EUROPEAN PATENT SPECIFICATION

(11) **EP 4 485 499 B1**
(45) Date of publication and mention of the grant of the patent: **05.11.2025**
(21) Application number: 23217249.4
(22) Date of filing: 15.12.2023
(51) Int. Cl.: H01J 37/32, H01L 21/67

(54) **PLASMA ETCHING METHOD AND APPARATUS**
PLASMAÄTZVERFAHREN UND VORRICHTUNG
PROCÉDÉ ET APPAREIL DE GRAVURE AU PLASMA

(30) Priority: 30.06.2023 GB 202310034
(43) Date of publication of application: 01.01.2025
(73) Proprietor: SPTS Technologies Limited, Newport Gwent NP18 2TA (GB)
(72) Inventor: BEACHEY, Adam Sean, Newport (GB)
(74) Representative: Wynne-Jones IP Limited

(56) References cited:
- EP-B1- 0 970 517
- JP-A- 2012 169 542
- US-A1- 2002 142 608
- US-A1- 2017 278 730

## Description

This invention relates to a method of plasma etching a semiconductor substrate. The invention relates also to an associated apparatus for plasma etching a semiconductor substrate.

In vacuum-based plasma etch and deposition tools in the semiconductor fabrication industry, it is challenging to avoid wafer movement and remove heat produced by a plasma or exothermic process from a wafer or substrate due to the subatmospheric pressure in the process chamber. The reduced pressure limits heat transfer due to poor convection and direct conduction of the heat from the substrate to the substrate support. In order to achieve optimal control of substrate temperature, electrostatic chucks or "ESCs" are used to control the temperature of a substrate in a vacuum system. Electrostatic attraction between the ESC and the substrate allows pressurization of cavities or channels between the substrate and the surface of the ESC with an inert gas such as He at a sufficiently high pressure to facilitate good thermal conduction between the substrate and the thermally controlled ESC. This process is known as backside pressurization. Even when the process chamber is operated at substantially lower pressures than the pressure between the ESC and the substrate, it is possible to maintain electrostatic clamping of the substrate and in turn tight temperature control.

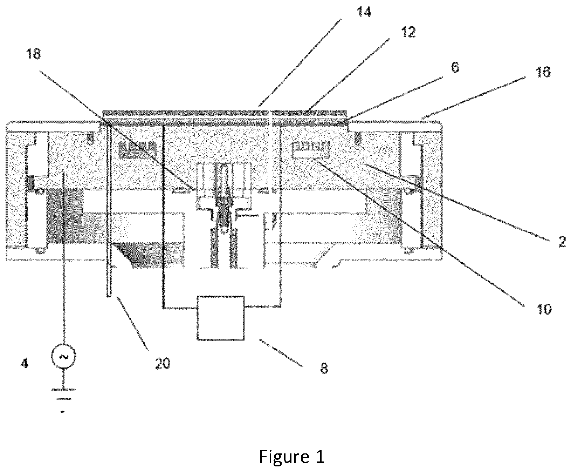

There are in general two distinct varieties of ESCs used to clamp substrates in vacuum systems, namely bipolar ("Coloumb") and monopolar ("Johnsen-Rahbek") ESCs. In both types, a metallic electrode or multiple electrodes are encapsulated in a dielectric structure which is then attached to a metallic substrate support, as shown in Figure 1. A substrate support 2, which is typically fabricated from aluminium or stainless steel, is connected to an RF supply 4 and the electrostatic chuck ESC 6 is attached to an upper surface of the substrate support 2. The ESC 6 has metallic electrodes sandwiched between two layers of dielectric material. The electrodes are attached to high voltage DC power supplies 8 which, for relatively thick ceramic layers greater than 0.5 mm in thickness, can supply up to +/- 9 kV. For thinner polymer layers, such as polyimide, the layer thickness can be less than 0.1mm, and the DC power is typically supplied at less than +/- 2 kV. Backside gas entry for the refrigerant gas, typically He or Ar, is provided by a pipe 20 in the substrate support 2 and allows gas to be injected between the substrate 12 and the surface of the ESC 6. Coolant channels 10 enable a flow of refrigerant to remove heat from the substrate support 2 while resistive heaters (not shown) can facilitate elevated temperature operation. Loading and unloading of the substrate 12 with coating 14 is achieved using a lift assembly 18. A shield ring 16, typically formed from ceramic, protects the substrate support 2 from the plasma and helps shape the plasma in the vicinity of the substrate 12.

In a bipolar ESC, there are at least two electrodes of opposite polarity which produce an electrostatic field at the back of the substrate. This requires the substrate to support charge movement, i.e. the substrate must be formed from a semiconductor or metallic material. As the majority of substrates processed in the semiconductor and optoelectrics industries are themselves semiconductors, bipolar ESCs are widely used.

Monopolar ESCs have an electrode or electrodes maintained at a single potential and rely on an external source of electrons to produce the electrostatic field. Generation of a plasma with the plasma chamber typically provides a current path to ground and, in turn, enables the monopolar ESC to clamp the substrate to the substrate support. To support this type of operation a very small amount of leakage current occurs through the insulating ceramic layers used in the ESC.

However, clamping with an ESC can give rise to problems when the etch process is completed, due to electrostatic charge retention in the substrate and the wafer support. The charge that has built up can take a considerable amount of time to dissipate - potentially several minutes - and as such increases the residence time in the process module as the substrate is effectively stuck to the ESC surface. This is highly undesirable for productivity reasons as it reduces the throughput of the tool. The time between the end of the plasma etch process and the point at which the substrate can be lifted from the substrate is known as the dechuck time. What is wanted is an improvement on established approaches that reduces dechuck times.

JP 2012 169542 A relates to an apparatus wherein the polarisation of the chuck is switched and the cooling gas pressure and flow volume is measured.

US 2017/278730 A1 relates to plasma processing apparatus and a plasma processing method that are favourable to hold a sample on a sample stage in a non contact manner. WO 98/43291 A1 also relates to apparatus and methods for clamping a semiconductor substrate on a bipolar electrostatic chuck in a plasma processing chamber.

US 2002/142608 A1 relates to a method of etching a substrate in a chamber on an electrostatic chuck, which defines a gas cooling path at the substrate/chuck interface.

The present invention, in at least some of its embodiments, seeks to address at least some of the above-mentioned problems and wants.

According to a first aspect of the invention there is provided a method of plasma etching a semiconductor substrate comprising the steps of:
positioning a semiconductor substrate on a substrate support within a chamber so that an upper surface of the semiconductor substrate can be exposed to the plasma etching and a lower surface of the semiconductor substrate is supported by the substrate support, wherein the substrate support comprises a bipolar electrostatic chuck ("ESC") and a cooling gas system for supplying a cooling gas to the lower surface at an associated pressure, and wherein the ESC comprises at least a first electrode and a second electrode;
plasma etching the semiconductor substrate; and
removing the semiconductor substrate from the substrate support after the plasma etching step is completed;
in which, during the plasma etching step: a cooling gas is supplied to the lower surface of the semiconductor substrate at an associated pressure; the ESC is switched between a first bipolar mode of operation in which a positive voltage is applied to the first electrode and a negative voltage is applied to the second electrode, and a second bipolar mode of operation in which a negative voltage is applied to the first electrode and a positive voltage is applied to the second electrode; and the pressure of the cooling gas is reduced when the ESC is switched between the first and second bipolar modes of operation with respect to the pressure at other times during the plasma etching step so that the semiconductor substrate remains positioned on the substrate support.

The pressure of the cooling gas can be reduced to a pressure of less than 1 Torr when the ESC is switched between the first and second bipolar modes of operation. The pressure of the cooling gas can be reduced to a pressure of less than 0.1 Torr when the ESC is switched between the first and second bipolar modes of operation. Lower pressures still can be employed and in practice it can be convenient to pump out a gas line that supplies the cooling gas to the lower surface of the ESC. The purpose is to prevent the cooling gas from lifting the semiconductor substrate at the times when the ESC is switched between the first and second bipolar modes of operation, because at these times the clamping provided by the ESC is substantially reduced.

The ESC can be switched between the first and second bipolar modes of operation a plurality of times during the plasma etching step. The ESC can be switched between the first and second bipolar modes of operation at least three times during the plasma etching step. In principle, the ESC can be switched between the first and second bipolar modes of operation any number of times and at any desired switching frequency in order to provide a favourable outcome in any given practical application. The ESC can be switched an even or an odd number of times. The ESC can be switched after operating in the first or second bipolar mode for 30 seconds or more, optionally 60 seconds or more, optionally 180 seconds or less.

The semiconductor substrate can attain a temperature of at least 140°C during the plasma etching step. The semiconductor substrate can attain a temperature of at least 150°C during the plasma etching step. The semiconductor substrate can attain a temperature of 300°C or less, optionally 250°C or less, during the plasma etching step. Surprisingly, the present inventors have found that substantial reductions in dechuck times can be realized by implementing the present invention in applications where the semiconductor substrate is plasma etched at relatively high temperatures.

The step of plasma etching the semiconductor substrate can be performed using a plasma generation device, such as an Inductively Coupled Plasma (ICP) device. The invention is not limited by the type of plasma etching performed, and non-ICP plasma etch techniques can be used.

An RF bias signal can be applied to the substrate support during and/or after the step of plasma etching the semiconductor substrate.

The method can comprise the further step of exposing the semiconductor substrate to a plasma formed in an inert gas or inert gaseous mixture, in which the further step is performed between the steps of plasma etching the semiconductor substrate and removing the semiconductor substrate from the substrate support. This plasma is an inert, typically low energy, plasma that can assist in 'dechucking' the semiconductor substrate by providing a current path to ground. In this way, any remaining charge can be removed from the semiconductor substrate and ESC surface. The inert gas or inert gaseous mixture can comprise He and/or Ar. The plasma generation device and/or the RF bias signal applied to the substrate support can be used to form the plasma in the inert gas or inert gaseous mixture.

The conditions used during the method can be such that the semiconductor substrate would be moved by the cooling gas if the ESC was switched between the first and second bipolar modes of operation without reducing the pressure of the cooling gas.

The semiconductor substrate can be an InP semiconductor substrate. Plasma etching of InP semiconductor substrates is typically performed at relatively high temperatures to remove volatile species. However, the invention is not limited to any particular semiconductor substrate. It is anticipated that the invention will be particularly well suited to the plasma etching of other semiconductor substrates that require relatively high processing temperatures.

The ESC can comprise a dielectric material. During the switching of the ESC between the first and second bipolar modes of operation the resistivity of the dielectric material can be in the range 10¹²-10¹³ ohms-cm.

According to a second aspect of the invention there is provided an apparatus for plasma etching a semiconductor substrate comprising:
a chamber;
a substrate support disposed within the chamber, wherein the substrate support comprises a bipolar electrostatic chuck ("ESC") and a cooling gas system for supplying a cooling gas to the lower surface at an associated pressure, and wherein the ESC comprises at least a first electrode and a second electrode;
a plasma generation device for sustaining a plasma within the chamber for etching the semiconductor substrate;
a mechanism for removing the semiconductor substrate from the substrate support; and
a controller configured to control the apparatus to perform a step of plasma etching the semiconductor substrate in which the ESC is switched between a first bipolar mode of operation in which a positive voltage is applied to the first electrode and a negative voltage is applied to the second electrode, and a second bipolar mode of operation in which a negative voltage is applied to the first electrode and a positive voltage is applied to the second electrode; and the pressure of the cooling gas is reduced when the ESC is switched between the first and second bipolar modes of operation with respect to the pressure at other times during the plasma etching step so that the semiconductor substrate remains positioned on the substrate support.

The apparatus plasma etches the semiconductor substrate using a method according to the first aspect of the invention.

The plasma generation device can be an Inductively Coupled Plasma (ICP) device. Other types of plasma generation device can be used.

The apparatus can further comprise a bypass valve in fluid communication with the cooling gas system and a gas pump, wherein the controller is configured to open and shut the bypass valve so that the pressure of the cooling gas is reduced when the ESC is switched between the first and second bipolar modes of operation by opening the bypass valve to exhaust cooling gas by the gas pump.

The electrodes of the ESC can be non-interdigitated. For example, the electrodes can be semicircular electrodes.

The ESC can comprise Al₂O₃

The mechanism for removing the semiconductor substrate from the substrate support can be any suitable mechanism, which can employ elements such as lift pins or another substrate lifting arrangement and a robotic arm. Such mechanisms are well known to the skilled reader.

For the avoidance of doubt, whenever reference is made herein to 'comprising' or 'including' and like terms, the invention is also understood to include more limiting terms such as 'consisting' and 'consisting essentially'.

Whilst the invention has been described above, it extends to any inventive combination of the features set out above, or in the following description, drawings or claims. For example, any features disclosed in relation to the first aspect of the invention can be combined with any features disclosed in relation to the second aspect of the invention.

Embodiments of the invention will now be described, by way of example only, with reference to the accompanying drawings, in which:
Figure 1 is a schematic illustration of a known substrate support;
Figure 2 is a semi-schematic cross-sectional view of an inductively coupled plasma apparatus;
Figure 3 shows a process sequence in accordance with the invention; and
Figure 4 is a schematic diagram of an ESC and a cooling gas system.

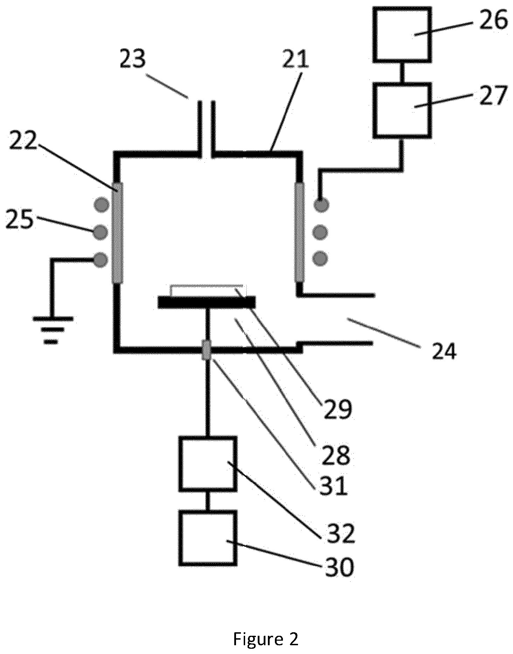

Figure 2 is a semi-schematic drawing of an apparatus 20 suitable for plasma etching a semiconductor substrate in accordance with the invention. Apparatus suitable for performing the methods of the present invention include an adapted SPTS Omega (RTM) ICP etch system, which is commercially available from SPTS Technologies Limited, located in Newport, South Wales, UK. All exemplary embodiments and comparative examples described below were performed using this apparatus.

The apparatus 20 comprises a chamber 21 and a plasma generation device for sustaining a plasma within the chamber. The chamber 21 comprises a dielectric cylindrical wall portion 22, a gas inlet 23, through which suitable gases can be introduced into the chamber 21, and a gas outlet 24 through which gases can be removed from the chamber using a suitable pump. The plasma generation device comprises a coil 25, which can be electrically driven by an RF power supply 26 via an impedance matching network 27. The coil 25 is disposed around the dielectric wall 22. The RF power supply 26 typically provides an RF power to the coil 25 at a frequency of 2-20 MHz, although lower frequencies can be employed (e.g. 380 kHz). The apparatus 20 further comprises a substrate support 28 onto which the semiconductor substrate 29 can be positioned for processing. The substrate support 28 comprises an electrostatic chuck (ESC) which uses a back pressure of a cooling gas during etching. The substrate support 28 is connected to an RF power supply 30 via a ceramic break 31 and an impedance matching network 32. The electrical power supply 30 provides an RF electrical bias to the substrate support 28. The RF power supply 30 typically provides an RF power with a frequency of 2-20 MHz, optionally 13.56 MHz, although lower frequencies can be employed (e.g. 375 kHz). A controller (not shown) is configured to control the apparatus, including the operation of the ESC and the supply of the cooling gas. The ESC is a bipolar ESC having two semicircular metal electrodes separated by a small gap of ~ 2mm embedded in Al₂O₃ ceramic layers. Alternative ceramics such as AIN or thin film polymer dielectric films could also be used.

The present invention utilises switching of the polarity of the voltages applied to the bipolar electrodes of the ESC. In particular, the ESC is switched between a first bipolar mode of operation in which a positive voltage is applied to the first electrode and a negative voltage is applied to the second electrode, and a second bipolar mode of operation in which a negative voltage is applied to the first electrode and a positive voltage is applied to the second electrode. At the times when the switching of the polarities takes place, the back pressure of the cooling gas is reduced to prevent the semiconductor substrate from lifting away from the substrate support. If the back pressure is not reduced then wafer movement will occur. The back pressure is then increased to a 'steady state' back pressure when the ESC is in either the first or second bipolar mode of operation. In this way, substantial reductions in the dechuck time can be realised, particularly for relatively high temperature plasma etching processes.

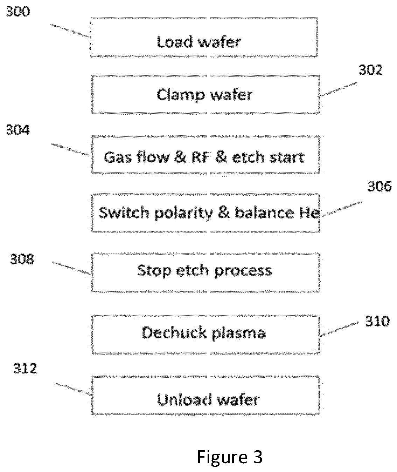

In Figure 3 a process sequence in accordance with the invention is presented. The SPTS Omega (RTM) system is a cluster tool and the process module is maintained under vacuum during normal operation. At step 300 a robot picks a wafer from a cassette or FOUP and places it onto lift pins on the ESC in the ICP etch chamber. The wafer is lowered onto the surface of the ESC and at 302 is electrostatically clamped by applying a high voltage (equal and opposite) to the two bipolar electrodes embedded in the ceramic layers of the ESC. At 304 a back pressure of a suitable cooling gas such as He is applied to the back of the wafer and the plasma etch process commences with process gases being supplied to the chamber and a plasma being generated. A back pressure of 3-30 Torr is typical, but this will depend on the particular application. During this plasma etch step (306) the switching of the polarity of the bipolar electrodes and the cycling of the cooling gas pressure commences. Once the plasma etch process is completed (as determined, for example, by time or end point) the final polarity / cooling gas cycling step would complete at step 308 and the process gases are replaced with an inert gas such as Ar. A dechucking plasma is then produced (310) which is continued for a fixed period of time, typically 10 to 60 seconds. After the dechucking plasma step is completed, the wafer is raised from the ESC by the lift pins to be picked up by the robot and removed from the chamber (312).

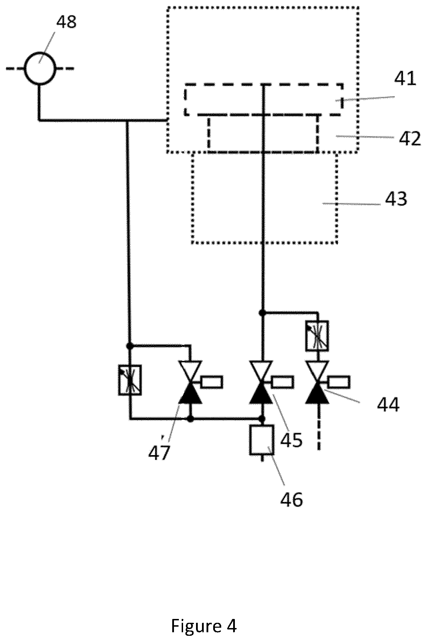

Figure 4 is a schematic diagram of an ESC and a cooling gas system. This ESC and cooling gas system was retrofitted to a commercial Omega (RTM) system to provide the adapted Omega (RTM) system used for the experiments described herein. Figure 4 shows the ESC 41, the vacuum chamber 42, the RF matching box 43, a nitrogen gas purge line 44, a He valve 45, a backside pressure unit 46, a He bypass valve 47, and a pump 48. The arrangement shown in Figure 4 is convenient since it enables fast gas switching. In particular, the presence of the He bypass valve 47 enables the line to the back of the ESC 41 to be directly pumped when this valve 47 and the He valve 45 are opened. This enables rapid (several seconds) control of the He pressure behind the semiconductor substrate. In this way, the back pressure of He can be reduced rapidly and then increased rapidly back to the usual, steady state He back pressure. This rapid switching of the He pressure can be readily synchronised with a polarity switching event.

### Comparative Examples

Experiments were conducted on 150mm Si wafers in the SPTS Omega ICP etch tool using a bipolar ESC operating at a high temperature and at a low temperature. A conventional etch and dechucking process was followed. The ICP source was operated at 13.56MHz and the ESC was RF biased at 13..

**Table 1 - Dechuck times as a function of ESC temperature and voltage.**

| Temperature (°C) | ESC Voltage (+/- kV) | Dechuck time (see) |
|---|---|---|
| 30 | 5 | 10 |
| 180 | 5 | 900 |
| 180 | 2 | 300 |

As can be seen in Table 1, under low temperature operation at a clamping voltage of - +/- 5kV, dechucking can occur in ~10 seconds. When the temperature of the ESC was increased using the same clamping voltage, the dechucking time increases dramatically to ~900 seconds. Table 1 shows that the dechucking time can be reduced to 300 seconds by lowering the clamping voltage to +/-2kV. However, a 300 second dechucking step is still not a practical solution. During the dechucking step an inert plasma formed in Ar or He is used to help remove change from the substrate.

Without wishing to be bound by any particular theory or conjecture, it is speculated that at elevated temperatures the Al₂O₃ ceramic layer covering the conductive electrodes becomes less resistive, dropping from ρ~ 10¹⁵ ohms-cm to ρ~ 10¹² - 10¹³ ohms-cm. This is believed to result in a Johnsen-Rahbek (J-R) contribution to the clamping electrostatic force. Typically, when ρ >10¹³ ohms-cm coulomb forces will be stronger than J-R forces, whilst when ρ<10¹⁰ ohms-cm J-R forces will dominate. This additional charging of the ceramic is believed to result in a longer dechuck time. These comparative examples demonstrate that conventional etching and dechucking techniques can result in dechuck times that are undesirably long, even if a dechucking plasma is used to assist in the removal of charge from the substrate.

### Examples

A series of experiments were carried out in accordance with the invention at an ESC temperature of 180°C. In the experiments, the polarity of the high voltage applied to the ESC electrodes was alternated for a period of time during the etch step while controlling the He back pressure. The back pressure of the He cooling gas was reduced several seconds prior to each voltage switch to avoid wafer movement when the related J-R clamping force is reduced. By reducing the He flow during each switching of the polarity of the applied ESC voltage, it was possible to maintain plasma etching and only produce minimal charging of the substrate, enabling a relatively swift dechucking cycle. After the etch step an inert dechucking plasma was generated. Table 2 describes the dechucking plasma conditions used. Typically ~ 500W RF power is applied to the ICP coil at 13.56MHz at a chamber pressure of ~5mTorr with an Ar flow of ~100sccm. The duration for the experiments was fixed at 30 seconds. The plasma etch step uses routine process conditions (with the exception of the switching of the ESC and the cooling gas back pressure) and therefore it is not necessary to provide detailed process details for this step.

**Table 2. Dechucking plasma conditions**

| | |
|---|---|
| Time (Secs) | 30 |
| RF Power (Watts) | 500 |
| Pressure (mTorr) | 5 |
| Ar flow (sccm) | 100 |

Table 3 describes three examples using various combinations of He back pressure, He switch / off times, intervals between each polarity switch, and dechuck times. In each case a default 30 second dechucking plasma was used before the wafer was successfully lifted from the ESC and handled out of the process chamber. These examples demonstrate that a commercially viable dechuck time of 30 seconds or less is readily achievable. Acceptable substrate retention and cooling was maintained.

**Table 3. Cycled polarity conditions to reduce dechuck times.**

| Process time (see) | He pressure (Torr) | He OFF time (see) | ESC Voltage (+/- kV) | Polarity switch time (see) | Dechuck time (see) |
|---|---|---|---|---|---|
| 300 | 8 | 10 | 2.5 | 60 | 30 |
| 300 | 5 | 5 | 2 | 60 | 30 |
| 480 | 5 | 10 | 2 | 120 | 30 |

Although the tests were carried out at 180°C using an Al₂O₃ bipolar ESC the same principle would apply over a wide range of temperatures where bipolar coulombic clamping is used when no plasma is present and where J-R force is significant when a plasma or alternative source of charge is introduced into the process chamber. For Al₂O₃ we would expect this to be the case over at least a temperature range of 140-300°C. With other ESC materials, the temperature range over which a measurable improvement in dechuck time can be observed is likely to differ. The invention is not limited to any particular operating temperature. Neither is the invention limited to any one plasma etching technique. The parameters and operating conditions described herein can be varied in order to suit any given application. For example, the number of times the ESC is switched between the first and second bipolar modes of operation, the period of time spent in each mode of operation prior to switching, and the timing and duration of the periods in which the back pressure of the cooling gas is reduced can be determined by the skilled reader using the principles described herein.

## Claims

1. A method of plasma etching a semiconductor substrate comprising the steps of:
positioning a semiconductor substrate (29) on a substrate support (28) within a chamber (21) so that an upper surface of the semiconductor substrate can be exposed to the plasma etching and a lower surface of the semiconductor substrate is supported by the substrate support (28), wherein the substrate support (28) comprises a bipolar electrostatic chuck ("ESC", 6) and a cooling gas system for supplying a cooling gas to the lower surface at an associated pressure, and wherein the ESC comprises at least a first electrode and a second electrode;
plasma etching the semiconductor substrate; and
removing the semiconductor substrate from the substrate support after the plasma etching step is completed;
in which, during the plasma etching step: a cooling gas is supplied to the lower surface of the semiconductor substrate at an associated pressure; the ESC is switched between a first bipolar mode of operation in which a positive voltage is applied to the first electrode and a negative voltage is applied to the second electrode, and a second bipolar mode of operation in which a negative voltage is applied to the first electrode and a positive voltage is applied to the second electrode; **characterised in that** the pressure of the cooling gas is reduced when the ESC is switched between the first and second bipolar modes of operation with respect to the pressure at other times during the plasma etching step so that the semiconductor substrate remains positioned on the substrate support.

2. A method according to claim 1 in which the pressure of the cooling gas is reduced to a pressure of less than 1 Torr when the ESC is switched between the first and second bipolar modes of operation.

3. A method according to claim 1 or claim 2 in which the ESC is switched between the first and second bipolar modes of operation a plurality of times during the plasma etching step.

4. A method according to claim 3 in which the ESC is switched between the first and second bipolar modes of operation at least three times during the plasma etching step.

5. A method according to any one of claims 1 to 4 in which the semiconductor substrate attains a temperature of at least 140°C during the plasma etching step.

6. A method according to any one of claims 1 to 5 comprising the further step of exposing the semiconductor substrate to a plasma formed in an inert gas or inert gaseous mixture, in which the further step is performed between the steps of plasma etching the semiconductor substrate and removing the semiconductor substrate from the substrate support.

7. A method according to claim 6 in which the inert gas or inert gaseous mixture comprises He and/or Ar.

8. A method according to any previous claim in which the semiconductor substrate would be moved by the cooling gas if the ESC was switched between the first and second bipolar modes of operation without reducing the pressure of the cooling gas.

9. A method according to any previous claim in which the semiconductor substrate is an InP semiconductor substrate.

10. A method according to any previous claim in which the ESC comprises a dielectric material and during the switching of the ESC between the first and second bipolar modes of operation the resistivity of the dielectric material is in the range 10¹²-10¹³ ohms-cm.

11. An apparatus (20) for plasma etching a semiconductor substrate using the method according to any previous claim, the apparatus comprising:
a chamber (21);
a substrate support (28) disposed within the chamber (21), wherein the substrate support (28) comprises a bipolar electrostatic chuck ("ESC", 6) and a cooling gas system for supplying a cooling gas to the lower surface at an associated pressure, and wherein the ESC comprises at least a first electrode and a second electrode;
a plasma generation device for sustaining a plasma within the chamber (21) for etching the semiconductor substrate (29);
a mechanism for removing the semiconductor substrate from the substrate support; and
a controller configured to control the apparatus to perform a step of plasma etching the semiconductor substrate in which the ESC is switched between a first bipolar mode of operation in which a positive voltage is applied to the first electrode and a negative voltage is applied to the second electrode, and a second bipolar mode of operation in which a negative voltage is applied to the first electrode and a positive voltage is applied to the second electrode; **characterised in that** the pressure of the cooling gas is reduced when the ESC is switched between the first and second bipolar modes of operation with respect to the pressure at other times during the plasma etching step so that the semiconductor substrate remains positioned on the substrate support.

12. An apparatus according to claim 9 in which the plasma generation device is an Inductively Coupled Plasma (ICP) device.

13. An apparatus according to claim 9 or claim 10 further comprising a bypass valve (47) in fluid communication with the cooling gas system and a gas pump (48), wherein the controller is configured to open and shut the bypass valve (47) so that the pressure of the cooling gas is reduced when the ESC is switched between the first and second bipolar modes of operation by opening the bypass valve to exhaust cooling gas by the gas pump (48).

14. An apparatus according to any one of claims 11 to 13 in which the electrodes of the ESC are non-interdigitated.

15. An apparatus according to any one of claims 11 to 14 in which the ESC comprises Al₂O₃.

## Patentansprüche

1. Verfahren zum Plasmaätzen eines Halbleitersubstrats, wobei das Verfahren die folgenden Schritte umfasst:
Positionieren eines Halbleitersubstrats (29) auf einem Substratträger (28) innerhalb einer Kammer (21), so dass eine Oberseite des Halbleitersubstrats dem Plasmaätzen ausgesetzt werden kann und eine Unterseite des Halbleitersubstrats von dem Substratträger (28) getragen wird, wobei der Substratträger (28) ein bipolares elektrostatisches Spannfutter ("ESC", 6) und ein Kühlgassystem zum Zuführen eines Kühlgases zu der Unterseite bei einem entsprechenden Druck umfasst, und wobei das ESC mindestens eine erste Elektrode und eine zweite Elektrode umfasst;
Plasmaätzen des Halbleitersubstrats; und
Entfernen des Halbleitersubstrats vom Substratträger, nachdem der Plasmaätzschritt abgeschlossen ist;
wobei während des Plasmaätzschritts: ein Kühlgas mit einem entsprechenden Druck an die Unterseite des Halbleitersubstrats geliefert wird; das ESC zwischen einem ersten bipolaren Betriebsmodus, in dem an die erste Elektrode eine positive Spannung und an die zweite Elektrode eine negative Spannung angelegt wird, und einem zweiten bipolaren Betriebsmodus umgeschaltet, in dem an die erste Elektrode eine negative Spannung und an die zweite Elektrode eine positive Spannung angelegt wird;
**dadurch gekennzeichnet, dass** der Druck des Kühlgases beim Umschalten des ESC zwischen dem ersten und dem zweiten bipolaren Betriebsmodus im Vergleich zum Druck zu anderen Zeitpunkten während des Plasmaätzschritts reduziert wird, sodass das Halbleitersubstrat auf dem Substratträger positioniert bleibt.

2. Verfahren nach Anspruch 1, wobei der Druck des Kühlgases auf einen Druck von weniger als 1 Torr reduziert wird, wenn das ESC zwischen dem ersten und dem zweiten bipolaren Betriebsmodus umgeschaltet wird.

3. Verfahren nach Anspruch 1 oder 2, wobei das ESC während des Plasmaätzschritts eine Vielzahl von Malen zwischen dem ersten und dem zweiten bipolaren Betriebsmodus umgeschaltet wird.

4. Verfahren nach Anspruch 3, wobei das ESC während des Plasmaätzschritts mindestens dreimal zwischen dem ersten und dem zweiten bipolaren Betriebsmodus umgeschaltet wird.

5. Verfahren nach einem der Ansprüche 1 bis 4, wobei das Halbleitersubstrat während des Plasmaätzschritts eine Temperatur von mindestens 140 °C erreicht.

6. Verfahren nach einem der Ansprüche 1 bis 5, umfassend den weiteren Schritt, das Halbleitersubstrat einem in einem Inertgas oder einer Inertgasmischung gebildeten Plasma auszusetzen, wobei der weitere Schritt zwischen den Schritten des Plasmaätzens des Halbleitersubstrats und des Entfernens des Halbleitersubstrats von dem Substratträger durchgeführt wird.

7. Verfahren nach Anspruch 6, wobei das Inertgas oder die Inertgasmischung He und/oder Ar umfasst.

8. Verfahren nach einem der vorstehenden Ansprüche, wobei das Halbleitersubstrat durch das Kühlgas bewegt würde, wenn das ESC zwischen dem ersten und dem zweiten bipolaren Betriebsmodus umgeschaltet würde, ohne den Druck des Kühlgases zu reduzieren.

9. Verfahren nach einem der vorstehenden Ansprüche, wobei das Halbleitersubstrat ein InP-Halbleitersubstrat ist.

10. Verfahren nach einem der vorstehenden Ansprüche, wobei das ESC ein dielektrisches Material umfasst und während des Umschaltens des ESC zwischen dem ersten und dem zweiten bipolaren Betriebsmodus der spezifische Widerstand des dielektrischen Materials im Bereich von 10¹² bis 10¹³ Ohm-cm liegt.

11. Einrichtung (20) zum Plasmaätzen eines Halbleitersubstrats unter Verwendung des Verfahrens nach einem der vorstehenden Ansprüche, wobei die Einrichtung umfasst:
eine Kammer (21);
einen Substratträger (28), der innerhalb der Kammer (21) angeordnet ist, wobei der Substratträger (28) ein bipolares elektrostatisches Spannfutter ("ESC", 6) und ein Kühlgassystem zum Zuführen eines Kühlgases zu der Unterseite bei einem entsprechenden Druck umfasst, und wobei das ESC mindestens eine erste Elektrode und eine zweite Elektrode umfasst;
eine Plasmaerzeugungsvorrichtung zum Aufrechterhalten eines Plasmas innerhalb der Kammer (21) zum Ätzen des Halbleitersubstrats (29);
einen Mechanismus zum Entfernen des Halbleitersubstrats von dem Substratträger; und
eine Steuerung, die konfiguriert ist, um die Einrichtung zu steuern, um einen Schritt des Plasmaätzens des Halbleitersubstrats durchzuführen, wobei das ESC zwischen einem ersten bipolaren Betriebsmodus, wobei an die erste Elektrode eine positive Spannung und an die zweite Elektrode eine negative Spannung angelegt wird, und einem zweiten bipolaren Betriebsmodus umgeschaltet wird, wobei an die erste Elektrode eine negative Spannung und an die zweite Elektrode eine positive Spannung angelegt wird; **dadurch gekennzeichnet, dass** der Druck des Kühlgases beim Umschalten des ESC zwischen dem ersten und dem zweiten bipolaren Betriebsmodus im Vergleich zum Druck zu anderen Zeitpunkten während des Plasmaätzschritts reduziert wird, sodass das Halbleitersubstrat auf dem Substratträger positioniert bleibt.

12. Einrichtung nach Anspruch 9, wobei es sich bei der Plasmaerzeugungsvorrichtung um eine Vorrichtung mit induktiv gekoppeltem Plasma (ICP) handelt.

13. Einrichtung nach Anspruch 9 oder 10, die ferner ein Bypassventil (47) in Fluidverbindung mit dem Kühlgassystem und einer Gaspumpe (48) umfasst, wobei die Steuerung konfiguriert ist, um das Bypassventil (47) zu öffnen und zu schließen, sodass der Druck des Kühlgases reduziert wird, wenn das ESC zwischen dem ersten und dem zweiten bipolaren Betriebsmodus umgeschaltet wird, indem das Bypassventil geöffnet wird, um Kühlgas durch die Gaspumpe (48) abzulassen.

14. Einrichtung nach einem der Ansprüche 11 bis 13, wobei die Elektroden des ESC nicht ineinander greifen.

15. Einrichtung nach einem der Ansprüche 11 bis 14, wobei das ESC Al₂O₃ umfasst.

## Revendications

1. Procédé de gravure au plasma d'un substrat semi-conducteur, comprenant les étapes consistant à :
positionner un substrat semi-conducteur (29) sur un support de substrat (28) à l'intérieur d'une chambre (21) de sorte qu'une surface supérieure du substrat semi-conducteur puisse être exposée à la gravure au plasma et qu'une surface inférieure du substrat semi-conducteur soit supportée par le support de substrat (28), dans lequel le support de substrat (28) comprend un mandrin électrostatique bipolaire (« ESC », 6) et un système de gaz de refroidissement permettant de fournir un gaz de refroidissement à la surface inférieure à une pression associée, et dans lequel l'ESC comprend au moins une première électrode et une seconde électrode ;
effectuer une gravure au plasma du substrat semi-conducteur ; et
retirer le substrat semi-conducteur du support de substrat après l'achèvement de l'étape de gravure au plasma ;
dans lequel, pendant l'étape de gravure au plasma : un gaz de refroidissement est fourni à la surface inférieure du substrat semi-conducteur à une pression associée ; on bascule l'ESC entre un premier mode de fonctionnement bipolaire dans lequel une tension positive est appliquée à la première électrode et une tension négative est appliquée à la seconde électrode, et un second mode de fonctionnement bipolaire dans lequel une tension négative est appliquée à la première électrode et une tension positive est appliquée à la seconde électrode ; **caractérisé en ce que** la pression du gaz de refroidissement est réduite quand on bascule l'ESC entre les premier et second modes de fonctionnement bipolaires par rapport à la pression à d'autres moments pendant l'étape de gravure au plasma de sorte que le substrat semi-conducteur reste positionné sur le support de substrat.

2. Procédé selon la revendication 1, dans lequel la pression du gaz de refroidissement est réduite à une pression inférieure à 1 Torr quand on bascule l'ESC entre les premier et second modes de fonctionnement bipolaires.

3. Procédé selon la revendication 1 ou la revendication 2, dans lequel on bascule l'ESC une pluralité de fois entre les premier et second modes de fonctionnement bipolaires pendant l'étape de gravure au plasma.

4. Procédé selon la revendication 3, dans lequel on bascule l'ESC au moins trois fois entre les premier et second modes de fonctionnement bipolaires pendant l'étape de gravure au plasma.

5. Procédé selon l'une quelconque des revendications 1 à 4, dans lequel le substrat semi-conducteur atteint une température d'au moins 140 °C pendant l'étape de gravure au plasma.

6. Procédé selon l'une quelconque des revendications 1 à 5, comprenant l'étape supplémentaire consistant à exposer le substrat semi-conducteur à un plasma formé dans un gaz inerte ou un mélange gazeux inerte, dans lequel l'étape supplémentaire est effectuée entre les étapes de gravure au plasma du substrat semi-conducteur et de retrait du substrat semi-conducteur du support de substrat.

7. Procédé selon la revendication 6, dans lequel le gaz inerte ou le mélange gazeux inerte comprend He et/ou Ar.

8. Procédé selon une quelconque revendication précédente, dans lequel le gaz de refroidissement déplacerait le substrat semi-conducteur si on basculait l'ESC entre les premier et second modes de fonctionnement bipolaires sans réduction de la pression du gaz de refroidissement.

9. Procédé selon une quelconque revendication précédente, dans lequel le substrat semi-conducteur est un substrat semi-conducteur InP.

10. Procédé selon une quelconque revendication précédente dans lequel l'ESC comprend un matériau diélectrique et pendant le basculement de l'ESC entre les premier et second modes de fonctionnement bipolaires la résistivité du matériau diélectrique est dans la plage de 10¹² à 10¹³ ohms-cm.

11. Appareil (20) de gravure au plasma d'un substrat semi-conducteur à l'aide du procédé selon une quelconque revendication précédente, l'appareil comprenant :
une chambre (21) ;
un support de substrat (28) disposé à l'intérieur de la chambre (21), dans lequel le support de substrat (28) comprend un mandrin électrostatique bipolaire (« ESC », 6) et un système de gaz de refroidissement permettant de fournir un gaz de refroidissement à la surface inférieure à une pression associée, et dans lequel l'ESC comprend au moins une première électrode et une seconde électrode ;
un dispositif de production de plasma permettant d'entretenir un plasma à l'intérieur de la chambre (21) afin de graver le substrat semi-conducteur (29) ;
un mécanisme permettant de retirer le substrat semi-conducteur du support de substrat ; et
un module de commande configuré pour commander l'appareil afin d'effectuer une étape de gravure au plasma du substrat semi-conducteur dans laquelle on bascule l'ESC entre un premier mode de fonctionnement bipolaire dans lequel une tension positive est appliquée à la première électrode et une tension négative est appliquée à la seconde électrode, et un second mode de fonctionnement bipolaire dans lequel une tension négative est appliquée à la première électrode et une tension positive est appliquée à la seconde électrode ;
**caractérisé en ce que** la pression du gaz de refroidissement est réduite quand on bascule l'ESC entre les premier et second modes de fonctionnement bipolaires par rapport à la pression à d'autres moments pendant l'étape de gravure au plasma de sorte que le substrat semi-conducteur reste positionné sur le support de substrat.

12. Appareil selon la revendication 9, dans lequel le dispositif de génération de plasma est un dispositif à plasma inductif (ICP).

13. Appareil selon la revendication 9 ou la revendication 10, comprenant en outre une vanne de dérivation (47) en communication fluidique avec le système de gaz de refroidissement et une pompe à gaz (48), dans lequel le module de commande est configuré pour ouvrir et fermer la vanne de dérivation (47) de sorte que la pression du gaz de refroidissement est réduite quand on bascule l'ESC entre les premier et second modes de fonctionnement bipolaires par ouverture de la vanne de dérivation afin d'évacuer du gaz de refroidissement au moyen de la pompe à gaz (48).

14. Appareil selon l'une quelconque des revendications 11 à 13, dans lequel les électrodes de l'ESC ne sont pas interdigitées.

15. Appareil selon l'une quelconque des revendications 11 à 14, dans lequel l'ESC comprend de l'Al₂O₃.
